# EUROPÄISCHE PATENTSCHRIFT

(11) **EP 1 882 403 B1**
(45) Veröffentlichungstag und Bekanntmachung des Hinweises auf die Patenterteilung: **08.10.2008**
(21) Anmeldenummer: 06725674.3
(22) Anmeldetag: 10.04.2006
(51) Int. Cl.: H05K 7/14

(54) **BEFESTIGUNGSVORRICHTUNG**
FIXING DEVICE
DISPOSITIF DE FIXATION

(30) Priorität: 13.05.2005 DE 102005022402
(43) Veröffentlichungstag der Anmeldung: 30.01.2008
(73) Patentinhaber: ROBERT BOSCH GMBH, 70442 Stuttgart (DE)
(72) Erfinder: HESSLER, Thomas, 72805 Lichtenstein (DE)
(86) Internationale Anmeldenummer: PCT/EP2006/061476
(87) Internationale Veröffentlichungsnummer: WO 2006/120107

(56) Entgegenhaltungen:
- EP-A- 1 033 909
- WO-A2-03/053745
- FR-A1- 2 657 490
- JP-A- 8 145 019
- JP-A- 2002 299 867
- JP-A- 2005 217 075

## Beschreibung

### Befestigungsvorrichtung

Die vorliegende Erfindung betrifft eine Vorrichtung zur Befestigung eines Schaltungsträgers mit einem Gehäuse eines Steuergeräts gemäß dem Oberbegriff des Anspruchs 1, wie aus der JP 08 145019 A bekannt.

Die JP 2005 217075 A offenbart eine Befestigungsvorrichtung zur Befestigung eines Schaltungsträgers mit einem oberen Gehäuseteil, einem unterem Gehäuseteil und einer im unteren Gehäuseteil umlaufenden Dichtung. Eine Auskragung ist am oberen Gehäuseteil ausgebildet, welche auf den Schaltungsträger drückt.

Derartige Vorrichtungen werden zur Befestigung von Schaltungsträgern, wie zum Beispiel gedruckten Schaltungen in Form von Leiterplatten, in Steuergeräten unterschiedlicher Ausführung verwendet. Dabei ist es üblich, dass die Befestigung des Schaltungsträgers durch eine Verschraubung, Rastung oder Verklebung erfolgt. Als Beispiel zur Illustration für eine Verrastung sei das Dokument JP-08125357 A genannt.

Weiterhin können die Schaltungsträger über bestimmte elastische Werkstoffe schwingungsfrei und/oder gedämpft befestigt sein. Hierbei wird auch eine Verschraubung verwendet, wie das Dokument JP-2002009464 A als Beispiel zeigt.

Die Lagerung einer Leiterplatte in einem elastischen umlaufenden Rahmen beschreibt das Dokument US 5,200,694. Hierbei wird eine Leiterplatte in dem elastischen Rahmen in einem Prüfadapter zur Prüfung ihrer elektrischen Funktionen aufgenommen, indem der Raum unter der Leiterplatte evakuiert wird, wobei diese auf Grund der Elastizität und des dichten Abschlusses des Rahmens mit der Leiterplatte nach unten in eine Prüfposition verstellt wird. In der Prüfposition sind Prüfspitzen zur Prüfung der elektrischen Funktionen der Leiterplatte auf dieser lösbar aufgebracht.

Verschraubungen gehören zu den Befestigungsmethoden, die bei der Fertigung schwer überwachbar und kostenaufwendig sind. Bei Verrastungen sind enge Toleranzen erforderlich und müssen eingehalten werden, um einen reibungslosen Fertigungsablauf zu gewährleisten. Eine Verklebung erfordert häufig eine Vorbehandlung der zu verklebenden Werkstoffpartner, wobei die Beständigkeiten der benutzten Werkstoffe hinsichtlich der Bestandteile des Klebers und der Vorbehandlungsmittel berücksichtigt werden muss.

### VORTEILE DER ERFINDUNG

Die erfindungsgemäße Vorrichtung zur Befestigung eines Schaltungsträgers in einem Gehäuse eines Steuergeräts gemäß Anspruch 1 bietet eine kostengünstige Befestigung ohne Verschraubung, Verrastung oder Verklebung und ohne. Einhaltung von engen Toleranzen.

Hierbei ist es von besonderem Vorteil, dass an den Schaltungsträger.und die Positionierung desselben nur geringe Anforderungen an die Toleranz gestellt werden.

In einer Ausführung ist es vorgesehen, dass die elastische Lagerelementeanordnung einen starren Abschnitt aufweist, der von dem ersten oder zweiten Gehäuseabschnitt gebildet wird. Somit kann der starre Abschnitt bei der Herstellung der Gehäuseabschnitte mit vorgesehen werden.

Erfindungsgemäß weist die elastische Lagerelementeanordnung einen elastischen Abschnitt auf, der im zusammengebauten Zustand des Gehäuses zur Festlegung des Schaltungsträgers gegenüber einem Gehäuseabschnitt und einer Wand eines Gehäuseabschnitts ausgebildet ist. Somit wird der Schaltungsträger vorteilhaft auch in horizontaler Richtung festgelegt, wobei das Einlegen des Schaltungsträgers in den ersten Gehäuseabschnitt des Gehäuses vorteilhaft einfach ohne Erfordernis enger Toleranzen erfolgen kann.

Erfindungsgemäß ist der elastische Abschnitt der Lagerelementeanordnung als ein einsetzbares
Element aus einem elastisch verformbaren Werkstoff gebildet. Somit kann über die Form eines solchen Elements bzw. den Werkstoff dieses Elements die Befestigungskraft beeinflusst werden.

In einer weiteren Ausführungsform ist vorgesehen, dass der elastische Abschnitt der Lagerelementeanordnung auf dem ersten oder zweiten Gehäuseabschnitt mit einer Auftragvorrichtung aufgetragen ist. Dieses eignet sich vorteilhaft für eine automatische Montage, bei welcher solche Auftragsvorrichtungen beispielsweise zum Auftragen von Dichtungen und dergleichen vorhanden sind.

In einer anderen Ausführungsform ist der elastische Abschnitt der Lagerelementanordnung mit dem ersten oder zweiten Gehäuseabschnitt in einem Zweikomponentenspritzgussverfahren gebildet. Dieses ist vorteilhaft, da somit die Lagerelementanordnung schon bei der Herstellung der Gehäuseabschnitte mit erstellt wird.

Eine weitere Ausführungsform sieht vor, dass der elastische Abschnitt der Lagerelementanordnung im Querschnitt ein Profil, vorzugsweise ein L-Profil aufweist. Damit wird vorteilhaft erreicht, dass bei einer geringen Befestigungskraft trotzdem eine vertikale und horizontale Festlegung des Schaltungsträgers im Gehäuse erfolgt, wobei ein Rand des L-Profils zwischen dem Rand des Schaltungsträgers und einer Gehäusewand angeordnet ist.

Der elastische Abschnitt der Lagerelementanordnung weist elektrische und/oder thermisch isolierende Eigenschaften auf. Dadurch wird sein Einsatz unabhängig von der Stelle des Schaltungsträgers, da die isolierenden Eigenschaften die Funktion des Schaltungsträgers nicht beeinflussen.

In einer anderen Ausgestaltung weist der elastische Abschnitt der Lagerelementanordnung elektrisch leitende Eigenschaften auf, wodurch Maßnahmen zur Einhaltung der elektromagnetischen Verträglichkeit (EMV) des Steuergeräts bzw. der Schaltung verbessert werden.

Zur Integration der Lagerelementanordnung beispielsweise in eine Kühlvorrichtung zur vorteilhaften Ableitung von Wärme aus dem Schaltungsträger weist der elastische Abschnitt der Lagerelementanordnung in einer weiteren Ausführungsform thermisch leitende Eigenschaften auf.

Die zu der elastischen Lagerelementanordnung korrespondierende Niederhalteranordnung am ersten oder zweiten Gehäuseabschnitt ist gegenüber liegend zur elastischen Lagerelementanordnung vorgesehen. Damit kann eine gezielte Krafteinleitung zum Zusammenpressen des elastischen Abschnitts der Lagerelementanordnung erfolgen, wobei eine vertikale Festlegung des Schaltungsträgers ermöglicht wird.

In einer weiteren Ausgestaltung ist die zu der elastischen Lagerelementanordnung korrespondierende Niederhalteranordnung ebenfalls als eine elastische Lagerelementanordnung ausgebildet.

Zur Erleichterung der Positionierung des Schaltungsträgers ist der starre Abschnitt der Lagerelementanordnung mit Führungselementen für den Schaltungsträger versehen.

Weitere Vorteile, Einzelheiten und Merkmale der Erfindung sind dem sich anschließenden Beschreibungsteil und den Zeichnungen zu entnehmen.

### ZEICHNUNGEN

Die Erfindung wird nachfolgend anhand des in den Figuren der Zeichnung angegebenen Ausführungsbeispiels näher erläutert.

Es zeigt dabei:
- FIG. 1: eine Teilschnittansicht einer ersten Ausführungsform einer erfindungsgemäßen Vorrichtung;
- FIG. 2: eine Seitenansicht eines Schaltungsträgers mit einer zweiten Ausführungsform der erfindungsgemäßen Vorrichtung;
- FIG. 3: eine beispielhafte Lagerelementanordnung in einer perspektivischen Ansicht; und
- FIG. 4: eine weitere beispielhafte Lagerelementanordnung einer perspektivischen Ansicht.

### BESCHREIBUNG DER AUSFÜHRUNGSBEISPIELE

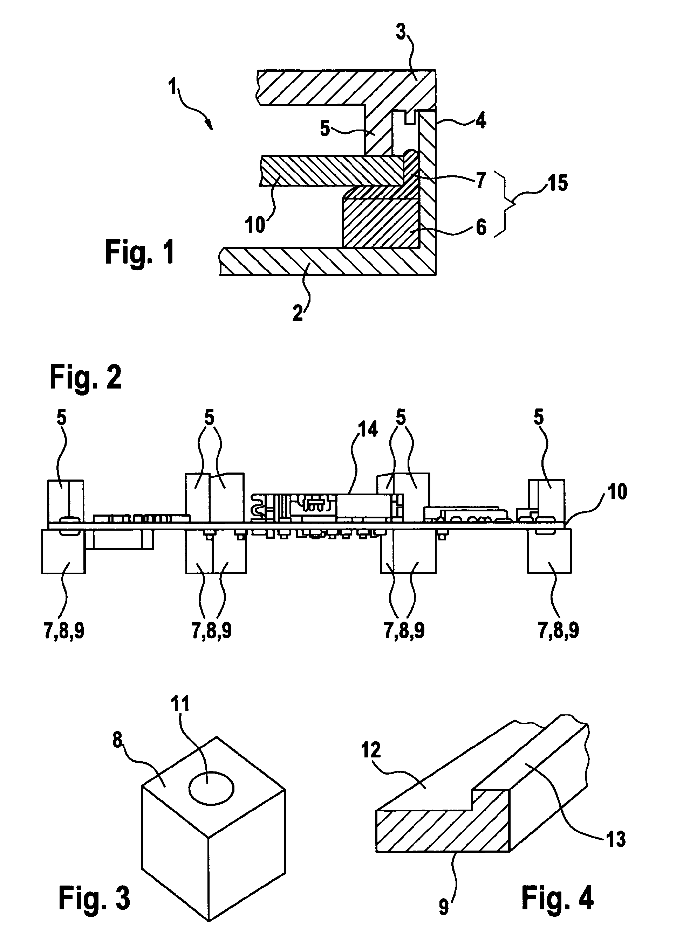

Eine erste Ausführungsform einer erfindungsgemäßen Vorrichtung ist in Fig. 1 in einer Teilschnittansicht dargestellt.

Ein Gehäuse 1 besteht aus einem ersten Gehäuseabschnitt 2, der ein Gehäuseunterteil mit einer umlaufenden Gehäusewand 4 bildet, und aus einem zweiten Gehäuseabschnitt 3, der ein Gehäuseoberteil bzw. einen Deckel bildet, der auf den ersten Gehäuseabschnitt 2 in bekannter Weise montierbar ist. Das Gehäuse 1 ist beispielsweise das Gehäuse eines Steuergeräts (nicht dargestellt) mit einem Schaltungsträger 10 für eine bestimmte Steuer- und/oder Regelschaltung mit Bauteilen 14 (siehe Fig. 2).

Der Schaltungsträger 10 ist hier eine gedruckte Schaltung in Form einer Leiterplatte, die in dem ersten Abschnitt 2 des Gehäuses 1 mittels einer ersten Lagerelementanordnung 15 gelagert ist. Die erste Lagerelementanordnung 15 weist eine starren Abschnitt 6 und einen elastischen Abschnitt 7 auf. Der starre Abschnitt 6 ist hierbei aus einem Teil des ersten Gehäuseabschnitts 2 gebildet, wobei der elastische Abschnitt 7 zwischen dem Schaltungsträger 10 und dem starren Abschnitt 6 bzw. dem ersten Gehäuseabschnitt 2 angeordnet ist.

Der zweite Gehäuseabschnitt 3 ist an seiner Unterseite mit einer Niederhalteranordnung 5 versehen, die in dem hier gezeigten zusammengebauten Zustand des Gehäuses 1 mit dem Schaltungsträger 10 auf dessen Oberseite über der Lagerelementanordnung 15 in Berührung steht und auf den Schaltungsträger 10 eine Druckkraft ausübt. Durch diese Druckkraft wird der Schaltungsträger 10 so auf den elastischen Abschnitt 7 der Lagerelementanordnung 15 gepresst, dass dieser elastisch komprimiert wird und ein an der Gehäusewand 4 befindlicher Abschnitt dadurch zwischen den seitlichen Rand des Schaltungsträgers 10 und die Seitenwand 4 des ersten Gehäuseabschnitts 2 schiebt. Somit ist der Schaltungsträger 10 durch die Niederhalteranordnung 5 des montierten zweiten Gehäuseabschnitts 3 in vertikaler Richtung und durch die elastische Lagerelementanordnung 15 in horizontaler Richtung festlegt. Es ist hier nur eine Seite dieser Anordnung des Gehäuses 1 dargestellt, wobei diese aber auch für die andere Seite und weitere Stellen im Gehäuse 1 gilt und leicht vorstellbar ist.

Die Niederhalteranordnungen 5 sind hier starr und einstückig mit dem zweiten Gehäuseteil 3 ausgebildet. Sie können aber auch zum Beispiel als Einsatzteile einzeln oder verbunden ausgestaltet sein.

Der zweite Gehäuseabschnitt 3 weist an seiner Unterseite einen nicht näher bezeichneten Vorsprung auf, der zur Zentrierung des zweiten Gehäuseabschnitts 3 auf dem ersten Gehäuseabschnitt 2 dienen kann. Zur Festlegung des Schaltungsträgers 10 ist eine solche Zentrierung jedoch nicht erforderlich. Dadurch vereinfacht sich seine Befestigung und die zugehörige Montage im Gehäuse 1 wesentlich. Der elastische Abschnitt 7 der Lagerelementanordnung 15 wird vor dem Einsetzen des Schaltungsträgers 10 in einfacher Weise in den ersten Gehäuseabschnitt 2 eingelegt, zum Beispiel an den Eckbereichen des Schaltungsträgers 10. Dazu kann der starre Abschnitt 6 entsprechende Ausnehmungen aufweisen.

Der elastische Abschnitt 7 besteht vorzugsweise aus einem silikonfreien elastischen Werkstoff, beispielsweise EPDM oder Viton. Der elastische Abschnitt 7 ist vorzugsweise kostengünstige Endlosware, die in geeignete relativ kurze Stücke zugeschnitten wird.

Fig. 2 zeigt ein Beispiel eines Schaltungsträgers 10 mit Bauteilen 14 und Lagerelementanordnungen 7, 8, 9, die auf bestimmte Auflagestellen des Schaltungsträgers 10 aufgeteilt sind. Ihnen sind jeweils Niederhalteranordnungen 5 gegenüber liegend angeordnet. Die Lagerelementanordnungen 8, 9 werden in Fig. 3 und 4 noch weiter erläutert.

Fig. 3 zeigt eine zweite Lagerelementanordnung 8, die aus einem elastischen Werkstoff besteht und in einfacher Weise leicht in den jeweiligen Gehäuseabschnitt 2, 3 einsetzbar ist. Die zweite Lagerelementanordnung 8 weist in dieser Ausführung eine Öffnung 11 auf, die beispielsweise zur Handhabung bei der Herstellung oder bei der Montage dienlich ist. Diese Öffnung 11 kann auch die Elastizität der Lagerclementanordnung 8 beeinflussen. Die Lagerelementanordnung 8 kann sowohl als Einzelstück aber auch als Endlosware ausgebildet sein.

In Fig. 4 ist eine dritte Lagerelementanordnung 9 dargestellt, die eine Auflagerfläche 12 und einen Rand 13 aufweist, wobei sie einen L-förmigen Querschnitt aufweist. Die Auflagerfläche 12 dient zur Auflage des Schaltungsträgers 10, wobei der Rand 13 zwischen dem Rand des Schaltungsträgers 10 und der Gehäusewand 4 vorgesehen ist (siehe Fig. 1). Diese geometrische Form der Lagerelementanordnung 9 eignet sich zum Beispiel in dem Fall, bei dem die Anpresskraft des zweiten Gehäuseabschnitts 3 nicht ausreicht oder nicht so hoch sein darf, um die Lagerelementanordnung 15 so zusammenzupressen, dass sich diese zwischen den Rand des Schaltungsträgers 10 und der Gehäusewand 4 schiebt.

Die zweite und dritte Lagerelementanordnung 8, 9 ist ohne starre Abschnitte dargestellt. Selbstverständlich können sie auch starre Abschnitte aufweisen.

Die Lagerelementanordnung 7, 8, 9, 15 wirkt weiterhin auch vibrationsdämpfend. Sie weist vorzugsweise elektrisch isolierende Eigenschaften auf, wodurch sie an jeder Stelle des Schaltungsträgers 10 angeordnet werden kann, ohne elektrische Fehlverbindungen oder Kurzschlüsse auszulösen. Die Lagerelementanordnung 7, 8, 9, 15 kann thermisch isolierende Eigenschaften aufweisen. Sie bildet mit der Niederhalteranordnung 5 eine einfache wirkungsvolle Vorrichtung zur Befestigung des Schaltungsträgers 10 im Gehäuse 1.

Die Erfindung ist nicht auf die oben erläuterten Ausführungsbeispiele beschränkt, sondern auf vielfältige Art und Weise modifizierbar.

So ist es beispielsweise denkbar, dass die elastischen Abschnitte 7 auf den starren Abschnitt 6 in einem Auftragsverfahren mit einer geeigneten Dispenservorrichtung aufgetragen werden.

Die Lagerelementanordnungen 8, 9, 15 können auch als Bestandteile des Gehäuses 1 in einem so genannten Zweikomponentenspritzgussverfahren bei der Herstellung der Gehäuseabschnitte 2, 3 erstellt werden.

Es ist auch möglich, einen weiteren elastischen Abschnitt auf der Niederhalteranordnung 5 aufzubringen. Wenn die Lagerelementanordnungen 8, 9 als Einzelteile ausgebildet sind, können diese auch zusätzliche Vorsprünge oder Ausnehmungen aufweisen mittels derer sie an dem jeweiligen Gehäuseabschnitt befestigbar sind.

Die Lagerelementanordnungen 8, 9, 15 können auch elektrisch leitende Eigenschaften aufweisen, zum Beispiel zur Einbindung in EMV-Maßnahmen. Auch thermisch leitende Eigenschaften sind möglich, um beispielsweise auf dem Schaltungsträger entstehende Wärme vorteilhaft in das Gehäuse oder andere Kühleinrichtungen abzuleiten.

### Befestigungsvorrichtung

### BEZUGSZEICHENLISTE

| | |
|---|---|
| 1 | Gehäuse |
| 2 | Erster Gehäuseabschnitt |
| 3 | Zweiter Gehäuseabschnitt |
| 4 | Gehäusewand |
| 5 | Niederhalteranordnung |
| 6 | Starrer Abschnitt |
| 7 | Elastischer Abschnitt |
| 8 | Zweite Lagerelementanordnung |
| 9 | Dritte Lagerelementanordnung |
| 10 | Schaltungsträger |
| 11 | Öffnung |
| 12 | Auflagerfläche |
| 13 | Rand |
| 14 | Bauteil |
| 15 | Erste Lagerelementanordnung |

## Patentansprüche

1. Vorrichtung zur Befestigung eines Schaltungsträgers (10) in einem Gehäuse (1) eines Steuergeräts mit:
- mindestens einer elastischen Lagerelementeanordnung (8, 9, 15) des Schaltungsträgers (10), die an einem ersten Gehäuseabschnitt (2) vorgesehen ist; und
- mindestens einer Niederhalteranordnung (5), die an einem zweiten Gehäuseabschnitt (3) vorgesehen ist,
wobei der zweite Gehäuseabschnitt (3) zur Befestigung des Schaltungsträgers (10) an dem ersten Gehäuseabschnitt (2) montierbar ist;
**dadurch gekennzeichnet,**
**dass** die elastische Lagerelementeanordnung (8, 9, 15) einen elastischen Abschnitt (7) aufweist, der im zusammengebauten Zustand des Gehäuses (1) zur Festlegung des Schaltungsträgers (10) gegenüber einem Gehäuseabschnitt (2, 3) und einer Wand (4) eines Gehäuseabschnitts (2, 3) ausgebildet ist; und
**dass** der elastische Abschnitt (7) der Lagerelementeanordnung (8, 9,15) als ein einsetzbares Element aus einem elastisch verformbaren Werkstoff gebildet ist.

2. Lagerungsvorrichtung nach Anspruch 1,
**dadurch gekennzeichnet,**
**dass** die elastische Lagerelementeanordnung (8, 9, 15) einen starren Abschnitt (6) aufweist, der von dem ersten oder zweiten Gehäuseabschnitt (2, 3) gebildet wird.

3. Lagerungsvorrichtung nach Anspruch 1 oder 2,
**dadurch gekennzeichnet,**
**dass** der elastische Abschnitt (7) der Lagerelementeanordnung (8, 9,15) auf dem ersten oder zweiten Gehäuseabschnitt (2, 3) mit einer Auftragvorrichtung aufgetragen ist.

4. Lagerungsvorrichtung nach einem der Ansprüche 1 bis 3,
**dadurch gekennzeichnet,**
**dass** der elastische Abschnitt (7) der Lagerelementeanordnung (8, 9, 15) mit dem ersten oder zweiten Gehäuseabschnitt (2, 3) in einem Zweikomponentenspritzgussverfahren gebildet ist.

5. Lagerungsvorrichtung nach einem der Ansprüche 1 bis 4,
**dadurch gekennzeichnet,**
**dass** der elastische Abschnitt (7) der Lagerelementeanordnung (8, 9, 15) im Querschnitt ein Profil, vorzugsweise ein L-Profil aufweist.

6. Lagerungsvorrichtung nach einem der Ansprüche 1 bis 5,
**dadurch gekennzeichnet,**
**dass** der elastische Abschnitt (7) der Lagerelementeanordnung (8, 9, 15) elektrisch und/oder thermisch isolierende Eigenschaften aufweist.

7. Lagerungsvorrichtung nach einem der Ansprüche 1 bis 5,
**dadurch gekennzeichnet,**
**dass** der elastische Abschnitt (7) der Lagerelementeanordnung (8, 9, 15) elektrisch leitende Eigenschaften aufweist.

8. Lagerungsvorrichtung nach einem der Ansprüche 1 bis 5,
**dadurch gekennzeichnet,**
das der elastische Abschnitt (7) der Lagerelementeanordnung (8, 9, 15) thermisch leitende Eigenschaften aufweist.

9. Lagerungsvorrichtung nach einem der Ansprüche 1 bis 8,
**dadurch gekennzeichnet,**
**dass** die zu der elastischen Lagerelementeanordnung (8, 9, 15) korrespondierende Niederhalteranordnung (5) am ersten oder zweiten Gehäuseabschnitt (2, 3) gegenüber liegend zur elastischen Lagerelementeanordnung (8, 9, 15) vorgesehen ist.

10. Lagerungsvorrichtung nach einem der Ansprüche 1 bis 9,
**dadurch gekennzeichnet,**
**dass** die zu der elastischen Lagerelementeanordnung (8, 9, 15) korrespondierende Niederhalteranordnung (5) ebenfalls als eine elastische Lagerelementeanordnung (8, 9, 15) ausgebildet ist.

11. Lagerungsvorrichtung nach Anspruch 2,
**dadurch gekennzeichnet,**
**dass** der starre Abschnitt (6) der Lagerelementeanordnung (8, 9, 15) Führungselemente für den Schaltungsträger (10) aufweist.

## Claims

1. Apparatus for fixing a circuit holder (10) in a housing (1) of a control device, having:
- at least one elastic bearing element arrangement (8, 9, 15) of the circuit holder (10) which is provided on a first housing portion (2); and
- at least one holding-down arrangement (5) which is provided on a second housing portion (3),
it being possible to mount the second housing portion (3) on the first housing portion (2) in order to fix the circuit holder (10);
**characterized**
**in that** the elastic bearing element arrangement (8, 9, 15) has an elastic portion (7) which, in the assembled state of the housing (1), is designed to secure the circuit holder (10) in relation to a housing portion (2, 3) and a wall (4) of a housing portion (2, 3); and
**in that** the elastic portion (7) of the bearing element arrangement (8, 9, 15) is formed as an insertable element from an elastically deformable material.

2. Bearing apparatus according to Claim 1,
**characterized**
**in that** the elastic bearing element arrangement (8, 9, 15) has a rigid portion (6) which is formed by the first or second housing portion (2, 3).

3. Bearing apparatus according to Claim 1 or 2,
**characterized**
**in that** the elastic portion (7) of the bearing element arrangement (8, 9, 15) is applied on the first or second housing portion (2, 3) with an application apparatus.

4. Bearing apparatus according to one of Claims 1 to 3,
**characterized**
**in that** the elastic portion (7) of the bearing element arrangement (8, 9, 15) is formed with the first or second housing portion (2, 3) using a two-component injection-moulding process.

5. Bearing apparatus according to one of Claims 1 to 4,
**characterized**
**in that** the elastic portion (7) of the bearing element arrangement (8, 9, 15) has a profile, preferably an L-profile, in cross section.

6. Bearing apparatus according to one of Claims 1 to 5,
**characterized**
**in that** the elastic portion (7) of the bearing element arrangement (8, 9, 15) has electrically and/or thermally insulating properties.

7. Bearing apparatus according to one of Claims 1 to 5,
**characterized**
**in that** the elastic portion (7) of the bearing element arrangement (8, 9, 15) has electrically conductive properties.

8. Bearing apparatus according to one of Claims 1 to 5,
**characterized**
**in that** the elastic portion (7) of the bearing element arrangement (8, 9, 15) has thermally conductive properties.

9. Bearing apparatus according to one of Claims 1 to 8,
**characterized**
**in that** the holding-down arrangement (5) which corresponds to the elastic bearing element arrangement (8, 9, 15) is provided on the first or second housing portion (2, 3) opposite the elastic bearing element arrangement (8, 9, 15).

10. Bearing apparatus according to one of Claims 1 to 9,
**characterized**
**in that** the holding-down arrangement (5) which corresponds to the elastic bearing element arrangement (8, 9, 15) is likewise designed as an elastic bearing element arrangement (8, 9, 15).

11. Bearing apparatus according to Claim 2,
**characterized**
**in that** the rigid portion (6) of the bearing element arrangement (8, 9, 15) has guide elements for the circuit holder (10).

## Revendications

1. Dispositif de fixation d'un support de circuit (10), dans un boîtier (1) comportant un appareil de commande ayant
- au moins un dispositif d'éléments de fixation, élastique, (8, 9, 15) du support de circuit (10), cet élément étant prévu sur un premier segment de boîtier (2)
- au moins un dispositif serre-flan (5) prévu sur un second segment de boîtier (3),
le second segment de boîtier (3) étant monté pour fixer le support de circuit (10) sur le premier segment (2),
**caractérisé en ce que**
le dispositif d'éléments de fixation élastique (8, 9, 15) comporte un segment élastique (7) qui, lorsque le boîtier (1) est assemblé, est réalisé pour fixer le support de circuit (10) par rapport à un segment de boîtier (2, 3) et une paroi (4) d'un segment de boîtier (2, 3) et
le segment élastique (7) du dispositif d'éléments de fixation (8, 9, 15) est un élément susceptible d'être installé, cet élément étant en un matériau élastiquement déformable.

2. Dispositif de fixation selon la revendication 1,
**caractérisé en ce que**
le dispositif d'éléments de fixation élastiques (8, 9, 15) comporte un segment rigide (6) formé par le premier et le second segment de boîtier (2,3).

3. Dispositif de fixation selon la revendication 1 ou 2,
**caractérisé en ce que**
le segment élastique (7) du dispositif d'éléments de fixation (8, 9, 15) est appliqué sur le premier et/ou le second segment de boîtier (2, 3) avec un dispositif d'application.

4. Dispositif de fixation selon l'une des revendications 1 à 3,
**caractérisé en ce que**
le segment élastique (7) du dispositif d'éléments de fixation (8, 9, 15) est formé d'un premier et d'un second segment de boîtier (2, 3) par un procédé d'injection à deux composants.

5. Dispositif de fixation selon l'une des revendications 1 à 4,
**caractérisé en ce que**
le segment élastique(7) du dispositif d'éléments de fixation (8, 9, 15) a en section un profil de préférence un profil en grand L.

6. Dispositif de fixation selon l'une des revendications 1 à 5,
**caractérisé en ce que**
le segment élastique (7) du dispositif d'éléments de fixation (8, 9, 15) présente des propriétés d'isolation électrique et/ ou thermique.

7. Dispositif de fixation selon l'une des revendications 1 à 5,
**caractérisé en ce que**
le segment élastique (7) du dispositif d'éléments de fixation (8, 9, 15) présente des propriétés de conduction électrique.

8. Dispositif de fixation selon l'une des revendications 1 à 5,
**caractérisé en ce que**
le segment élastique (7) du dispositif d'éléments de fixation (8, 9, 15) présente des propriétés de conduction thermique.

9. Dispositif de fixation selon l'une des revendications 1 à 8,
**caractérisé en ce que**
le dispositif serre-flan (5) correspondant au dispositif d'éléments de fixation élastique (8, 9, 15) est prévu sur le premier ou sur le second segment de boîtier (2, 3) en regard du dispositif d'éléments de fixation élastique (8, 9, 15).

10. Dispositif de fixation selon l'une des revendications 1 à 9,
**caractérisé en ce que**
le dispositif serre-flan (5) correspondant au dispositif d'éléments de fixation élastique (8, 9, 15) est également réalisé sous la forme d'un dispositif d'éléments de fixation élastique (8, 9, 15).

11. Dispositif de fixation selon la revendication 2,
**caractérisé en ce que**
le segment rigide (6) du dispositif d'éléments de fixation (8, 9, 15) comporte des éléments de guidage pour le support de circuit (10).
